# EUROPEAN PATENT APPLICATION

(11) **EP 0 673 108 A1**
(43) Date of publication of application: **20.09.1995**
(21) Application number: 95301491.7
(22) Date of filing: 08.03.1995
(51) Int. Cl.: H02M 7/00, H02M 1/00, G09F 3/02, H05K 7/14

(54) **Identification icon indicia for plug-in units of a power distribution system**

(30) Priority: 18.03.1994 US 210212
(71) Applicant: AT&T Corp., New York, NY 10013-2412 (US)
(72) Inventor: Alden, Tor Andrew, Bernardsville, New Jersey 07924 (US); Somdahl, Sonja K., Rockwall, Texas 75087 (US); Fontana, Edward Clark, Rockwall, Texas 75087 (US)
(74) Representative: Johnston, Kenneth Graham

(57) **Abstract**

Icon indicia is provided on input output and intermediate power units to permit proper matching of plug-in units in a power chassis with each other and with the the input and output units. The indicia is in a co-ordinated matrix format with input icons on a designated chroma background to identify input voltages and output icons on a second designated chroma background to identify output voltages. Icons on the plug units and background chroma are coordinated with related icons and background chroma at the same matrix position on other plug in units and the input and output units to assure the compatibility of all the units. A craftsman inserting plug-in units onto a shelf of the power chassis need merely check the icon designations with their chroma background with the input and output unit icons and their associated background chroma to be assured of inserting the correct plug-in unit into the particular shelf.

## Description

### Field of the Invention

This invention relates to a power distribution system having a plurality of differing plug-in units for processing power and in particular to icon indicia attached to the plug-in units to facilitate insertion in to plug-in stations included in a support chassis and connected to a backplane of the power distribution system.

### Background of the Invention

Power distribution units normally can accommodate a variety of plug in units which plug-in into various back planes and enable the distribution of various voltage and current levels of power. Given a particular power distribution scheme, the plug-in power units used must function in harmony with one another. This means that they must be properly selected for addition to the backplane. These selections are normally made by a crafts person who is familiar with the requirements of the plug-in units. It is not uncommon for the incorrect unit to be plugged in due to time and other pressures causing plug-in unit preselection to be made incorrectly. This may be due to confusing markings on the units or failure to understand the proper unit needed for a proper plug-in.

### Summary of the Invention

Therefore icon and background radiant energy (i.e. chroma) indicia is provided, as claimed in the appended claims, to permit proper matching of plug-in units in a power chassis with one another and with the operative power system.

In an illustrative embodiment the indicia is in a co-ordinated matrix format with input graphical icons on a designated chroma background to identify input voltages and graphical output icons on a second designated chroma background to identify output voltages. Icons on the plug units are coordinated with related icons on the input and output units to assure the compatibility of all the units.

A craftsman inserting units onto a shelf of the power housing need merely check the icon designations with their chroma background with the input and output unit icons and their associated background chroma to be assured of inserting the correct plug-in unit into the particular shelf.

### Brief Description of the Drawing

FIG. 1 is a pictorial schematic of a power system cabinet including a plurality of plug in units which operate in concert to process power;
FIG. 2 is a frontal view of one of the shelves of the cabinet of FIG. 1 showing the faces of the plug in units and the end input and output units of the shelf;
FIG. 3 is a label for an output unit of the power system cabinet;
FIG. 4 is a label for a plug-in power processing unit for insertion on the shelf of the power system cabinet; and
FIG. 5 is a label for an input unit of the power system cabinet.

### Detailed Description

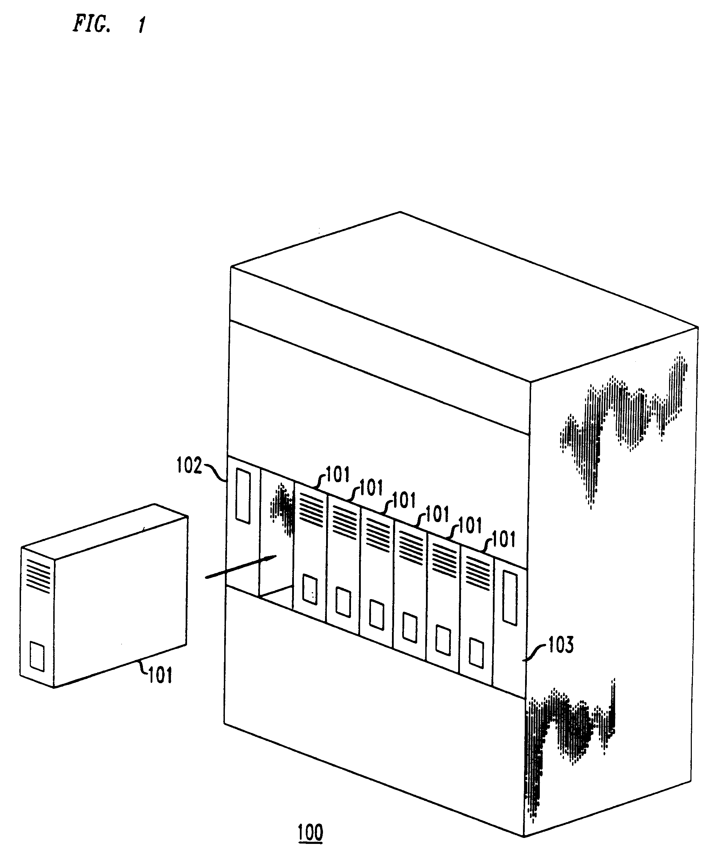

A power distribution chassis or cabinet 100 as shown in the FIG. 1 includes a plurality of power units 101 which slide into a shelf of the cabinet and connect to a backplane at the rear of the shelf. Power units 102 and 103 at the end of the shelf provide power processing and inter connection to a power source and to equipment to be powered. One of the plug-in power units is shown prior to plug in into the shelf and consequent connection to the backplane. The back plane electrically connects the plug-in units into the electrical system between input and output power units and provides power processing of the electrical power there between. As such the plug-in units must be compatible with electrical and mechanical specifications of the power units 102 and 103 at the opposing ends of the shelves.

To insure compatibility in selection of the plug-in power units to other plug-in units and to the end units of the cabinet the end units and the plug in units are marked with indicia by way of icons and background chroma, associated with the icon that insure that craft personal select the proper plug- in units to place on the shelf of the chassis. Each end unit has identifying icon and background chroma indicia on the labels 112 and 113 while each of the plug in units has a label 111 that includes identifying icons and background chroma indicia.

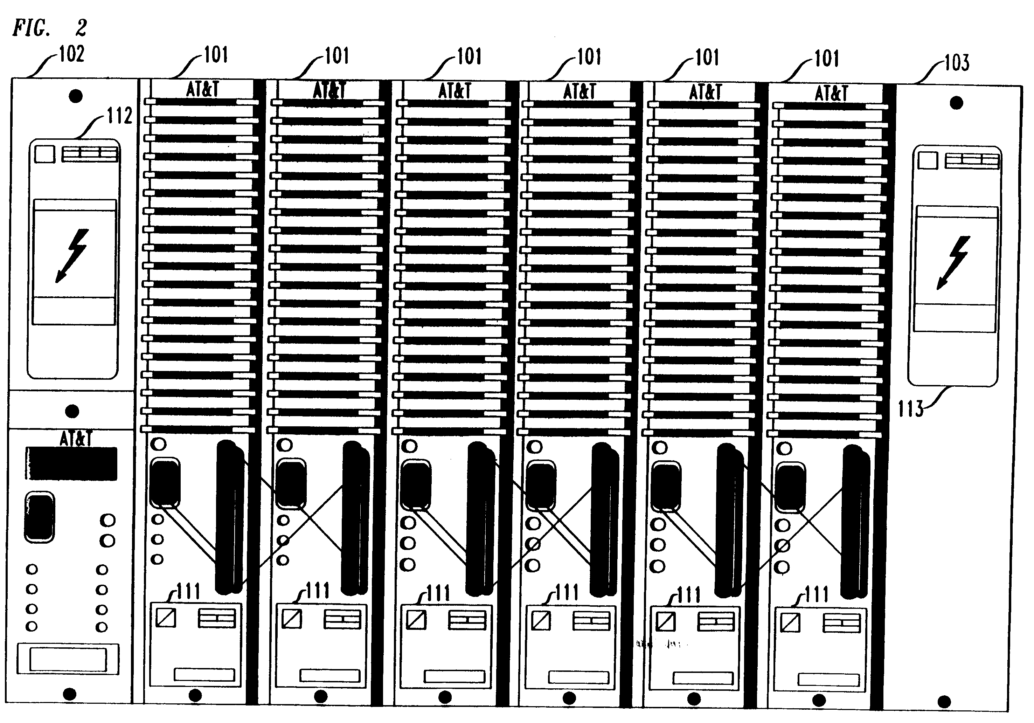

The nature of the indicia marking is illustrated in the FIG. 2 which depicts a frontal view of the shelf of FIG. 1 and the individual units with the labels and their chroma indicia and icons. Each label is comprised of at least an icon, a background chroma, having a distinct frequency of reflected or radiated light, and numerical information and an operational designation of the unit. The input unit for accepting power input 102 has an identification label 112 that identifies the purpose and power/voltage ratings of the input unit 102. The output unit 103 similarly has an identification label that identifies the purpose and power/voltage ratings of the output unit 103. Each of the plug-in units 101 connected to a backplane in the power cabinet and operates to process power from the input unit 102 and deliver the processed power to the output unit 103 .

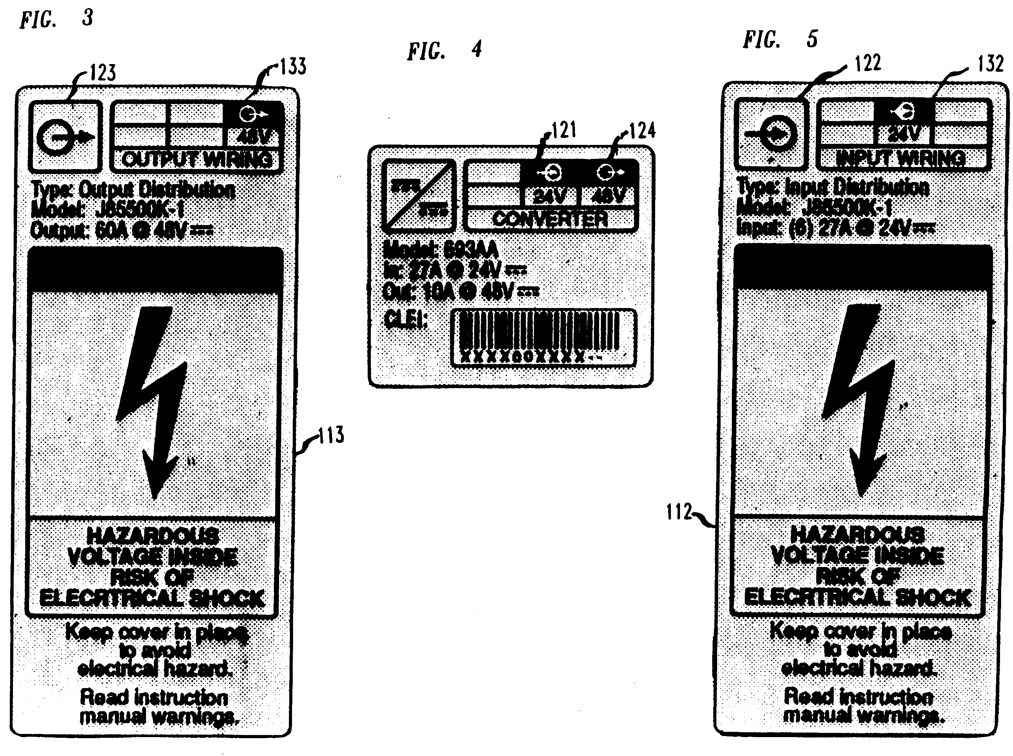

The labels are shown in detail in the FIGs. 3, 4 and 5. The label 112 of the input power unit 102 is shown in the FIG. 5. The output power unit label 113 is shown in FIG 3 and the label 111 of the plug-in units is shown in the FIG. 4.

The input unit label 112, shown in FIG. 5, includes an input icon 122 identifying it as an input circuit. Associated with the icon 122 is a matrix of information in which the icon is replicated as part of a matrix tabular format which includes the icon 132 on a background of a first chroma with a first radiant energy frequency (i.e. color) in one of the matrix slots. Immediately below it is a voltage designation of the input voltage and below that the designation input wiring.

The output unit label 113, shown in FIG. 3, includes an output icon 123 identifying it as an output circuit. Associated with the icon 123 is a matrix of information in which the icon is replicated as part of a tabular matrix format which includes the icon 133 on a background of a second chroma with a second radiant energy frequency (i.e. second color) in one of the matrix slots. Immediately below it is a voltage designation of the output voltage and below that the designation output wiring.

The plug-in unit label is shown in the FIG.4 includes the designation "converter" in a matrix setting. Above it on the left is an input icon 121, of a color back ground keyed to the input voltage value and below it a voltage rating. The input icon 121 is on the left, as is the input unit 102 as shown in fig. 2. An output icon 124 is positioned to the right as is the output unit 103 as shown in the FIG. 2 and below it is the output voltage rating for the plug-in converter unit to which the icon background is color keyed. As is apparent units may be matched by reference to identical icon designations in identical matrix positions, or by reference to a chroma background in identical matrix positions, or by numerical designations or by combinations of the above. The specific position of indicia in the matrix matches the same indicia in the matrix of another unit to which it is compatible. In the matter of neutral back ground chroma in a specific position, the unit will be compatible with another unit having any chroma in that position.

A craftsman inserting units onto a shelf of the power housing need merely check the common icon designations and or with their related chroma background with each other and/or with the input and output unit icons and their associated background chroma to be assured of inserting the correct plug-in unit into the particular shelf.

## Claims

1. A power plant, comprising:
a supporting infrastructure including a shelf for accepting a plurality of modular power processing circuits;
an input distribution unit;
an output distribution unit;
a plurality of intermediate power processing units arranged in a linear series and electrically connected intermediate the input distribution unit and the output distribution unit in order to process power supplied from the input distribution unit and deliver power to the output distribution unit;
the input distribution unit including means for accepting power from a power source and
CHARACTERIZED BY
further including a first identification member providing an indication of an output voltage supplied to the plurality of intermediate power processing units by a label having a first radiant energy frequency visually displaying a first color in a first specific matrix position;
the output distribution unit including means for distributing power to a load and further including a second identification member providing an indication of an appropriate input voltage to be supplied to it by the plurality of intermediate power processing units by a label having a second radiant energy frequency visually displaying a second color in a second specific matrix position;
identification indicia associated with each of the intermediate power processing units, including;
a third identification member providing an indication of an acceptable input voltage accepted from the input distribution unit by including the first radiant energy frequency visually displaying the first color in the first specific matrix position, wherein a match between the voltage from the input distribution and the acceptable input voltage is indicated by an identity of the radiant energy frequency displayed; and
the third identification member providing an indication of an output voltage of the intermediate distribution unit supplied to the output distribution unit by including the second radiant energy frequency visually displaying the second color in the second specific matrix position, wherein a match between the output voltage of the intermediate distribution unit and a voltage acceptable to the output distribution unit is indicated by an identity of the radiant energy frequency.

2. A power plant as claimed in claim 1, comprising:
a first icon associated with the acceptable input voltage and appearing on the first and third identification members and a second icon associated with the voltage acceptable to the output distribution unit and appearing on the second and third identification members.

3. A power plant as claimed in claim 1, comprising:
wherein the icons and associated identification is structured into a matching matrix layout so that related indicia is similar
